# EUROPEAN PATENT APPLICATION

(11) **EP 4 443 662 A1**
(43) Date of publication of application: **09.10.2024**
(21) Application number: 22900597.0
(22) Date of filing: 01.12.2022
(51) Int. Cl.: H01R 13/04, B60L 53/302, B60L 53/16, H05K 7/20, H01R 13/66

(54) **CHARGING GUN COMPRISING COOLING STRUCTURE, AND CHARGING PILE**

(30) Priority: 02.12.2021 CN 202111462083
(71) Applicant: Changchun Jetty Automotive Technology Co., Ltd., Changchun City, Jilin Province 130000 (CN)
(72) Inventor: WANG, Chao, Changchun, Jilin 130000 (CN)
(74) Representative: Boult Wade Tennant LLP
(86) International application number: PCT/CN2022/135843
(87) International publication number: WO 2023/098793

(57) **Abstract**

Disclosed are a charging gun having a cooling structure, and a charging pile. The charging gun having a cooling structure includes a charging terminal (1), a charging gun body (2), and a cooling structure (3), where the charging gun body (2) and the cooling structure (3) are disposed in sequence, the charging terminal (1) passes through the charging gun body (2) along a direction from the charging gun body (2) to the cooling structure (3), at least part of the charging terminal (1) is sleeved in the cooling structure (3) in a matching manner, and a cooling medium can flow in the cooling structure (3) to cool the charging terminal (1). The charging gun having the cooling structure has a liquid cooling structure, which can avoid the situation that the safety of a whole vehicle is affected due to a circuit fault caused by structure failure resulting from a high temperature of the terminal.

## Description

### RELATED APPLICATION

This application claims priority to Chinese Patent Application No. 202111462083.2, entitled "Charging Gun having Cooling Structure, and Charging Pile" filed on December 2, 2021.

### TECHNICAL FIELD

The present disclosure relates to the field of charging devices, and specifically to a charging gun having a cooling structure, and a charging pile.

### BACKGROUND

During normal use, when a high-speed direct-current charging device operates, a charging terminal will produce a large amount of heat, resulting in high temperature. Connectors and fasteners at a wire connecting position and around will fail due to the high temperature, which affects the normal use of the charging device, causes short circuit and open circuit, and even causes the risk of electric shock, endangering lives. Therefore, the high-speed direct-current charging device without a cooling system cannot meet the high-speed charging requirements of new energy vehicles.

### SUMMARY

In order to avoid too high temperature of a charging terminal during operation, the present disclosure provides a charging gun having a cooling structure, and a charging pile. The charging gun having a cooling structure includes a liquid cooling structure, which can avoid the situation that the safety of a whole vehicle is affected due to a circuit fault caused by structure failure resulting from a high temperature of the terminal.

To solve the technical problems, the present disclosure adopts the following technical solutions.

A charging gun having a cooling structure, including a charging terminal, a charging gun body, and a cooling structure. The charging gun body and the cooling structure are disposed in sequence, the charging terminal passes through the charging gun body along a direction from the charging gun body to the cooling structure, at least part of the charging terminal is disposed in the cooling structure in a matching manner, and the cooling structure is capable of cooling the charging terminal by a cooling medium in the cooling structure.

A charging pile, including the above charging gun having a cooling structure.

The present disclosure has the following beneficial effects:
1. A liquid cooling structure (i.e., the cooling structure) is included to avoid the situation that the safety of a whole vehicle is affected due to a circuit fault caused by structure failure resulting from a high temperature of the terminal.
2. The function and assembly requirements of the high-voltage direct-current charging terminal can be fully met.
3. It can be applied to the functional design of high-voltage direct-current charging terminals for all new energy vehicles, become a structural standard for high-voltage direct-current charging terminals, and lead the future design direction of high-voltage direct-current charging terminals.

### BRIEF DESCRIPTION OF DRAWINGS

The drawings of the specification constituting a part of the present application are used to provide a further understanding of the present disclosure. Schematic embodiments of the present disclosure and their descriptions are used to explain the present disclosure and do not constitute improper limitations to the present disclosure.
FIG. 1 is a schematic exploded view of a charging gun having a cooling structure according to Embodiment 1 of the present disclosure;
FIG. 2 is a schematic exploded view of a charging gun having a cooling structure according to Embodiment 2 of the present disclosure;
FIG. 3 is a schematic three-dimensional view of a charging gun having a cooling structure according to Embodiment 2 of the present disclosure;
FIG. 4 is a schematic overall view of a charging gun having a cooling structure according to Embodiment 2 of the present disclosure;
FIG. 5 is a schematic front view of a charging gun having a cooling structure according to Embodiment 2 of the present disclosure;
FIG. 6 is a cross-sectional view taken along line A -A in FIG. 5;
FIG. 7 is a schematic diagram of a charging terminal according to Embodiment 4;
FIG. 8 is a schematic diagram of a cooling structure according to Embodiment 4; and
FIG. 9 is a schematic diagram of a cooling structure according to Embodiment 5.
   1. charging terminal; 2. charging gun body; 3. cooling structure; 4. signal ground terminal;
   11. terminal body; 12. heat dissipation portion; 13. connecting portion; 14. threaded hole;
   15. disassembly portion; 16. insulating head; 17. screw;
   21. mounting groove; 22. sealing ring; 23. accommodating cavity;
   31. cooling-medium accommodating cavity; 32. cooling medium inlet;
   33. cooling medium outlet; 34. cooling jacket; 35. connecting board;
   36. upper half cooling structure body; 37. lower half cooling structure body;
   38. cooling structure sheath; and
   121. heat dissipation protrusion.

### DETAILED DESCRIPTION

It should be noted that, in the absence of a conflict, embodiments of this application can be combined with features in the embodiments. The present disclosure will be described in detail below with reference to the accompanying drawings and in conjunction with embodiments.

A charging gun having a cooling structure includes a charging terminal 1, a charging gun body 2, and a cooling structure 3. The charging gun body 2 and the cooling structure 3 are disposed in sequence. The charging terminal 1 passes through the charging gun body 2 along a direction from the charging gun body 2 to the cooling structure 3. At least one part of the charging terminal 1 is disposed in the cooling structure 3 in a matching manner, and the cooling structure 3 is capable of cooling the charging terminal 1 by a cooling medium in the cooling structure 3.

Further, the charging terminal 1 includes a heat dissipation portion 12, and the heat dissipation portion 12 is disposed in the cooling structure 3.

A cooling-medium accommodating cavity 31 is formed in the cooling structure 3, and the cooling-medium accommodating cavity 31 allows the cooling medium to flow therein. A cooling medium inlet 32 and a cooling medium outlet 33 are formed on the cooling structure 3. The cooling medium may be cyclically and continuously inputted to the cooling-medium accommodating cavity 31 of the cooling structure 3 to cool the charging terminal 1. The cooling medium may be, for example, air, refrigerated air, or water. In order to adapt to a cold environment, the cooling medium may also be an anti-freezing medium (such as a mixture of ethanediol and water). The cooling medium may also be insulating liquid (such as transformer oil), so as to avoid the situation that the safety of a whole vehicle is affected due to a circuit fault caused by structure failure resulting from a high temperature of the terminal.

Further, the charging gun body 2 and the cooling structure 3 are integrally formed, that is, the charging gun body 2 and the cooling structure 3 are connected as a whole. The design of integral forming can increase the overall strength of the charging gun body 2 and the cooling structure 3, and also reduce the mounting steps. Certainly, in some embodiments where the cooling structure 3 needs to be conveniently replaced, the charging gun body 2 and the cooling structure 3 may be detachably connected to each other.

Several specific embodiments of the charging gun having a cooling structure will be described in detail below.

### Embodiment 1

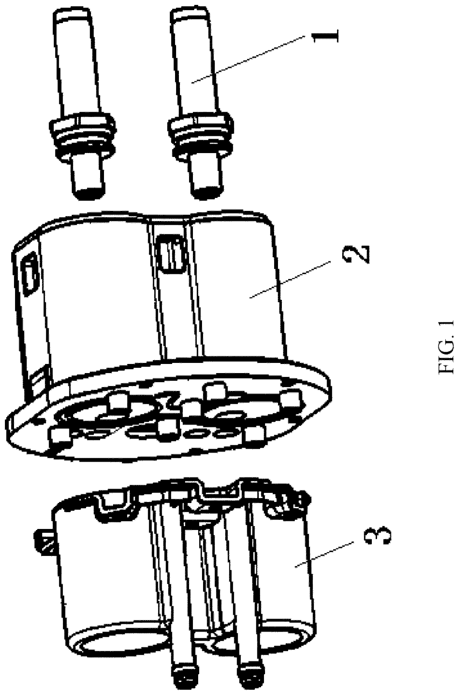

In this embodiment, the charging gun body 2 and the cooling structure 3 are disposed in sequence, one part of the charging terminal 1 is disposed in the charging gun body 2, the other part of the charging terminal is disposed in the cooling structure 3, the cooling structure 3 is detachably connected to the charging terminal 1, and the cooling medium can flow in the cooling structure 3 to cool the charging terminal 1, as shown in FIG. 1.

### Embodiment 2

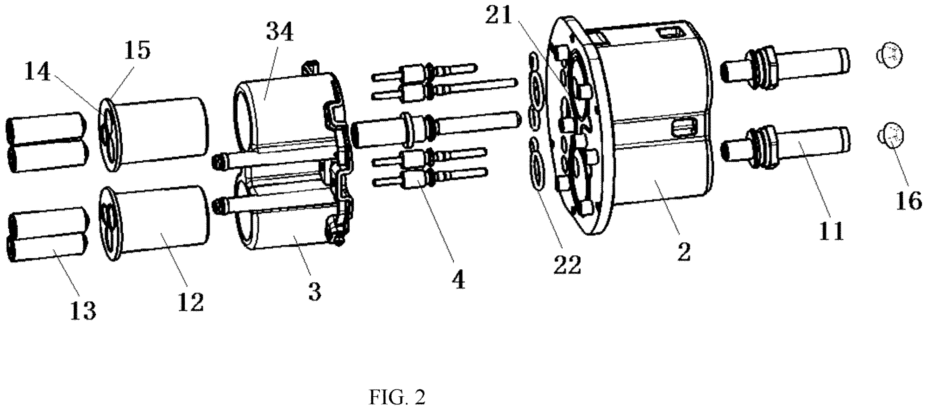

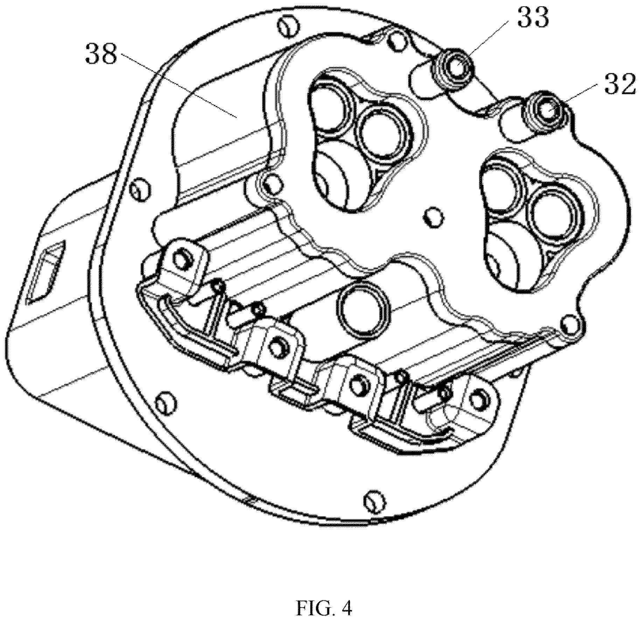

In this embodiment, the charging terminal 1 is of a split structure, the charging terminal 1 includes a terminal body 11 and a heat dissipation portion 12 disposed in a in a front-to-back sequence. The terminal body 11 is detachably connected to the heat dissipation portion 12, the terminal body 11 is mainly located in the charging gun body 2, the heat dissipation portion 12 is located in the cooling structure 3, and the cooling structure 3 is matched to and sleeved outside the heat dissipation portion 12, and a cooling structure sheath 38 is disposed outside the cooling structure 3, as shown in FIG. 2 to FIG. 6.

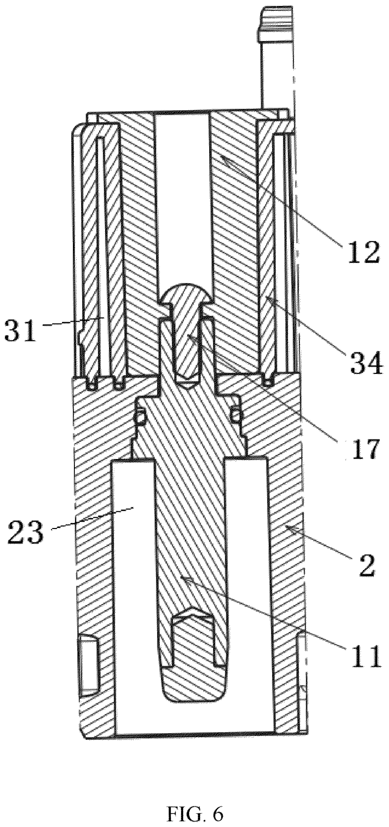

An accommodating cavity 23 is formed in a front end of the charging gun body 2. As shown in FIG. 6, a detachable structure is disposed inside the accommodating cavity 23, an opening is formed at a front end of the accommodating cavity 23, and the charging terminal 1 is inserted into the accommodating cavity 23 through the opening of the accommodating cavity 23 and is detachably connected to the charging gun body 2 by the detachable structure (such as by means of plugging).

In this embodiment, the terminal body 11 may be connected to the heat dissipation portion 12 by a thread structure, a bolt or an internal thread is disposed on the terminal body 11, a corresponding internal thread or bolt is disposed on the heat dissipation portion 12, and a torque of the thread structure for screw connection is 0.1 N·m to 30 N·m.

For example, when the bolt is disposed on the terminal body 11, a through hole is formed on the heat dissipation portion 12, and the bolt on the terminal body 11 passes through the through hole on the heat dissipation portion 12 and is connected to a nut;
alternatively, when the internal thread is disposed on the terminal body 11, a through hole is formed on the heat dissipation portion 12, and a screw 17 passes through the through hole on the heat dissipation portion and is connected to the internal thread on the terminal body 11, as shown in FIG. 6;
alternatively, when the internal thread is disposed on the heat dissipation portion 12, a through hole is formed on the terminal body 11, and a screw 17 passes through the through hole on the terminal body 11 and is connected to the internal thread on the heat dissipation portion 12;
alternatively, when the bolt is disposed on the heat dissipation portion 12, a through hole is formed on the terminal body 11, and the bolt on the heat dissipation portion 12 passes through the through hole on the terminal body 11 and is connected to a nut.

In order to verify the influence of the torque of screwing the terminal body 11 with the heat dissipation portion 12 on the electrical connection and mechanical connection performance of the terminal body 11 and the heat dissipation portion 12, the inventor selects the same terminal bodies 11 and the same heat dissipation portions 12, tightens them with different torques, and tests a contact resistance between the terminal body 11 and the heat dissipation portion 12 and tests a connection between the terminal body 11 and the heat dissipation portion 12 that have subjected to a vibration test. Test results are as shown in Table 1.

In a test method for the contact resistance between the terminal body 11 and the heat dissipation portion 12, a micro-resistance tester is used, one test end of the micro-resistance tester is placed on the terminal body 11, and the other end of the micro-resistance tester is placed on the heat dissipation portion 12, where the same placement position is required in each test; and then a contact resistance value on the micro-resistance tester is read. In this embodiment, the contact resistance of greater than 1 mS2 is unqualified.

In the vibration test, connected samples are placed on a vibration test bench, and then it is observed whether the terminal body 11 and the heat dissipation portion 12 are loose after 300 vibration cycles, where each cycle requires vibration in six directions, a frequency is 100 Hz, and a unidirectional acceleration is 40 m/s². In this embodiment, the situation that the terminal body 11 and the heat dissipation portion 12 are loose is unqualified.

**Table 1: Influence of different torques for terminal body 11 and heat dissipation portion 12 on electrical connection and mechanical connection performance of terminal body 11 and heat dissipation portion 12**

| Torque (N m) for terminal body 11 and heat dissipation portion 12 | | | | | | | | | | | | | |
|---|---|---|---|---|---|---|---|---|---|---|---|---|---|
| 0.01 | 0.05 | 0.1 | 0.5 | 1 | 3 | 5 | 10 | 15 | 20 | 25 | 30 | 32 | 35 |

| Contact resistance (mΩ) between terminal body 11 and heat dissipation portion 12 | | | | | | | | | | | | | |
|---|---|---|---|---|---|---|---|---|---|---|---|---|---|
| 1.16 | 1.05 | 0.96 | 0.94 | 0.91 | 0.88 | 0.86 | 0.83 | 0.81 | 0.79 | 0.74 | 0.71 | 0.71 | 0.71 |

| Connection between terminal body 11 and heat dissipation portion 12 | | | | | | | | | | | | | |
|---|---|---|---|---|---|---|---|---|---|---|---|---|---|
| Loos e | Loos e | Non-loose | Non-loose | Non-loose | Non-loose | Non-loose | Non-loose | Non-loose | Non-loose | Non-loose | Non-loose | Non-loose | Non-loose |

It can be seen from the above Table 1 that when the torque of screwing the terminal body 11 with the heat dissipation portion 12 is less than 0.1 N·m, the contact resistance is unqualified; moreover, the terminal body 11 and the heat dissipation portion 12 are loose after the vibration test. Therefore, the inventor sets the minimum torque of screwing the terminal body 11 with the heat dissipation portion 12 to 0.1 N·m. When the torque of screwing the terminal body 11 with the heat dissipation portion 12 is greater than 30 N·m, the contact resistance cannot be further reduced. Therefore, the inventor determines that the torque of screwing the terminal body 11 with the heat dissipation portion 12 is 0.1 N·m to 30 N·m.

In this embodiment, the terminal body 11 may be in clamped connection with the heat dissipation portion 12. For example, a clamping jaw or a clamping groove is disposed on the terminal body 11, a corresponding clamping groove or clamping jaw is disposed on the heat dissipation portion 12, and a connecting force between the clamping jaw and the clamping groove is 5 N to 500 N.

In order to test the influence of the connecting force between the clamping jaw and the clamping groove on the electrical conductivity, the inventor selects ten pairs of clamping jaws and clamping grooves with the same shape and with the expandable and contractible slits of the same width for a connecting force test. Test results are as shown in Table 2.

**Table 2: Influence of different connecting forces between clamping jaws and clamping grooves on electrical conductivity**

| | | | | | | | | | | |
|---|---|---|---|---|---|---|---|---|---|---|
| Connecting force (N) | 40 | 50 | 80 | 100 | 200 | 300 | 400 | 500 | 520 | 550 |
| Electrical | 99.5% | 99.6% | 99.6% | 99.6% | 99.6% | 99.8% | 99.7% | 99.8% | 99.8% | 99.8% |
| conductivity | | | | | | | | | | |
| | | | | | | | | | | |
| Connecting force (N) | 3 | 4 | 5 | 6 | 8 | 10 | 15 | 20 | 25 | 30 |
| Electrical conductivity | 97.8% | 98.4% | 99.1% | 99.1% | 99.3% | 99.3% | 99.4% | 99.4% | 99.4% | 99.5% |

It can be seen from Table 2 that when the connecting force between the clamping jaw and the clamping groove is less than 5 N or greater than 500 N, the electrical conductivity of the terminal body 11 and the heat dissipation portion 12 is significantly reduced, which cannot meet the actual requirement. When the connecting force between the clamping jaw and the clamping groove is greater than 5 N or less than 500 N, the electrical conductivity of the terminal body 11 and the heat dissipation portion 12 is better. When the connecting force between the clamping jaw and the clamping groove is greater than 15 N and less than 300 N, the when the connecting force between the clamping jaw and the electrical conductivity is also excellent. However, when the connecting force is greater than 300 N, the electrical conductivity of the terminal body 11 and the heat dissipation portion 12 is not improved significantly, and it is difficult for processing. Therefore, the inventor prefers that the connecting force between the clamping jaw and the clamping groove is 15 N to 300 N.

The specification of the charging gun body 2 conforms to one selected from various different specification standards such as a Chinese alternating current (AC) standard, a Chinese direct current (DC) standard, a European AC standard, a European DC standard, an American AC standard, an American DC standard, a Japanese AC standard, a Japanese DC standard, and a super charging standard. The charging gun body 2 may be made of a hard plastic, such as PA66 and fiber glass or other materials with good strength.

A disassembly portion 15 is disposed at a rear end of the charging terminal 1, and a section of the disassembly portion 15 is flat or polygonal. The section of the disassembly portion 15 may be flat or polygonal. The disassembly portion 15 is of a flanging structure, and the disassembly portion 15 abuts against the cooling structure 3. The terminal body 11 and the heat dissipation portion 12 are disposed in a front-to-back sequence, and a connecting portion 13 is located in a rear part of the heat dissipation portion 12.

Exemplarily, the heat dissipation portion 12 is internally provided with a plurality of threaded holes 14, the connecting portion 13 is of a cylindrical structure, the connecting portion 13 is in threaded connection with the heat dissipation portion 12, the heat dissipation portion 12 is connected to the terminal body 11 by the screw 17 or by a conductive adhesive with high strength, and an insulating head 16 is disposed at a front end of the terminal body 11. The insulating head 16 is a plastic head, and the insulating head 16 may be assembled or integrally formed with the terminal body 11. The insulating head 16 has a roughly cylindrical contour, and a tail end of the insulating head 16 is in threaded connection with the terminal body 11. The insulating head 16 is made of an insulating material, such as polypropylene (PP), polyamide (PA), or acrylonitrile butadiene styrene (ABS). The insulating head 16 has an insulating function to prevent danger caused by electric shock.

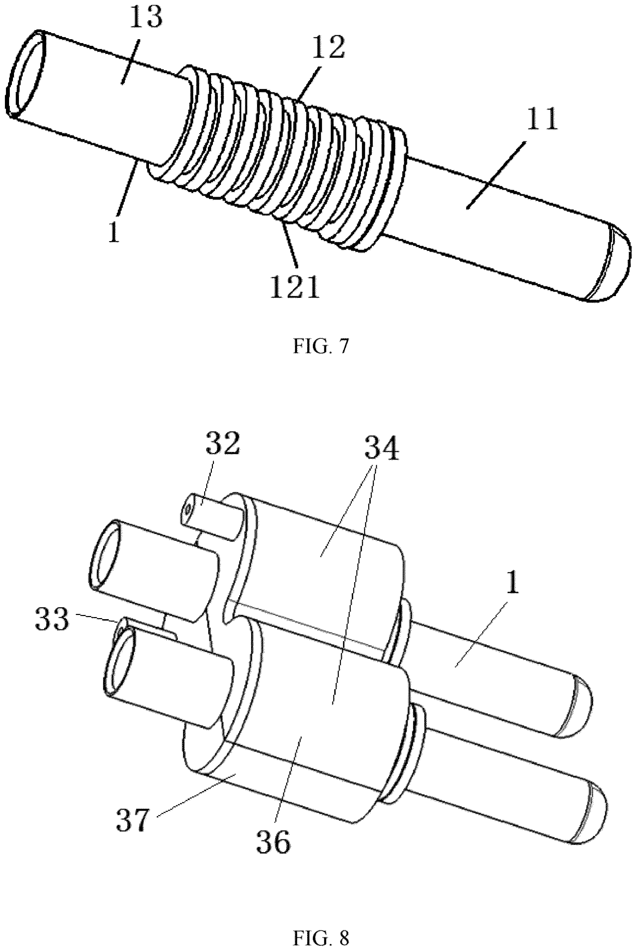

Two connecting portions 13 are disposed in one heat dissipation portion 12, an axis of the connecting portion 13 is parallel to an axis of the heat dissipation portion 12, an axis of the terminal body 11 coincides with the axis of the heat dissipation portion 12, a rear part of the connecting portion 13 is provided with an external thread, and the connecting portion 13 is in threaded connection with the heat dissipation portion 12, as shown in FIG. 6 and FIG. 7.

In some embodiments, the number of charging terminals 1 is plural, the cooling structure 3 includes a plurality of cooling jackets 34, the cooling jackets 34 are sleeved on peripheries of the heat dissipation portions 12 in a one-to-one correspondence manner, and a cooling medium inlet 32 and a cooling medium outlet 33 are formed on each of the cooling jackets 34.

In this embodiment, the charging gun having a cooling structure may include two charging terminals 1, the cooling structure 3 includes two cooling jackets 34, the cooling jacket 34 is in a cylindrical structure, and the cooling jackets 34 are sleeved outside the charging terminals 1 in a one-to-one correspondence manner. The section of the cooling-medium accommodating cavity 31 is in an annular structure, and the cooling-medium accommodating cavity 31 is sleeved in a side wall of the cooling jacket 34, that is, one cooling-medium accommodating cavity 31 is formed in each cooling jacket 34, and the axis of the cooling-medium accommodating cavity 31 coincides with the axis of the cooling jacket 34, as shown in FIG. 2 to FIG. 6.

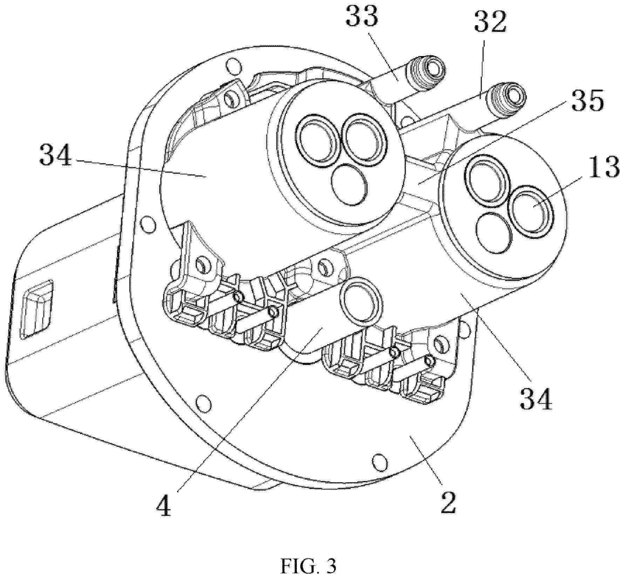

In this embodiment, the two cooling jackets 34 are disposed in parallel and at intervals. The two cooling jackets 34 are substantially of the same size and of the same construction. A connecting channel is disposed between the cooling jackets 34, and the cooling-medium accommodating cavities 31 of the cooling jackets 34 communicate with each other through the connecting channel. During specific implementation, a connecting plate 35 may be disposed between the two cooling jackets 34, and a connecting channel may be disposed in the connecting plate 35, where the length of the connecting plate 35 is substantially the same as the length of the cooling jacket 34, as shown in FIG. 2 and FIG. 3.

For the number of cooling medium inlets 32 and the number of cooling medium outlets 33, there may be one inlet and one outlet (i.e. one cooling medium inlet 32 and one cooling medium outlet 33), one inlet and two outlets (i.e. one cooling medium inlet 32 and two cooling medium outlets 33), or two inlets and one outlet (i.e. two cooling medium inlets 32 and one cooling medium outlet 33). There may also be two inlets and two outlets (i.e. two cooling medium inlets 32 and two cooling medium outlets 33), which has the advantage that the short circuit problem of a power transmission device when using a non-insulating medium can be avoid.

For example, the cooling structure 3 includes two cooling jackets 34, where the two cooling jackets 34 are a first cooling jacket and a second cooling jacket respectively. The cooling medium inlet 32 is located on the first cooling jacket, the cooling medium inlet 32 is located on the second cooling jacket, or the cooling medium inlet 32 is located on the first cooling jacket and the second cooling jacket. The cooling medium outlet 33 is located on the first cooling jacket, the cooling medium outlet 33 is located on the second cooling jacket, or the cooling medium outlet 33 is located on the first cooling jacket and the second cooling jacket.

In this embodiment, there are one cooling medium inlet 32 and one cooling medium outlet 33, and the cooling structure 3 includes two cooling jackets 34, where the two cooling jackets 34 are a first cooling jacket and a second cooling jacket respectively; the cooling medium inlet 32 is located on the first cooling jacket; and the cooling medium outlet 33 is located on the second cooling jacket, as shown in FIG. 2 to FIG. 4.

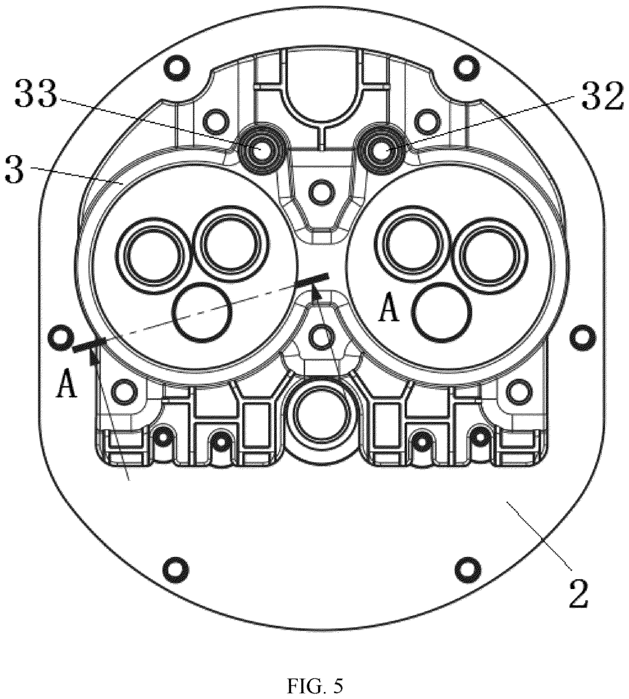

In this embodiment, a mounting groove 21 is formed on a mounting surface of the charging gun body 2 facing the cooling structure 3, that is, a mounting groove 21 is formed on a rear side surface of the charging gun body 2, an opening is formed at a front end of the cooling structure 3, the front end of the cooling structure 3 is matched with and inserted into the mounting groove 21, the cooling structure 3 is connected to the charging gun body 2 to form a cooling-medium accommodating cavity 31, and a front end of the cooling-medium accommodating cavity 31 is closed by the charging gun body 2, as shown in FIG. 5 and FIG. 6.

A sealing ring 22 is disposed between the cooling structure 3 and the charging gun body 2 to ensure the sealing property of the cooling-medium accommodating cavity 31 and prevent the cooling medium from overflowing to cause short circuit and electric shock accidents. The cooling structure 3 may also be made of a plastic (exemplarily a hard plastic, such as PA66 and fiber glass or other materials with good strength). An injection molding process is used for the cooling structure 3, and a mold stripping angle is 0.5°.

A connecting portion 13 is disposed in the heat dissipation portion 12, and the connecting portion 13 is connected to a charging gun cable by one or more selected from resistance welding, friction welding, ultrasonic welding, arc welding, laser welding, electron beam welding, pressure diffusion welding, magnetic induction welding, screwing, clamping, splicing, and crimping.

The resistance welding refers to a method in which a strong current is used to pass through a contact point between an electrode and a workpiece, and a contact resistor generates heat to implement welding.

The friction welding refers to a method in which heat generated by friction on the contact surface of a workpiece is used as a heat source to cause plastic deformation of the workpiece produce under pressure for welding.

The ultrasonic welding refers to that high-frequency vibration waves are used to be transmitted to the surfaces of two objects that need to be welded, and the surfaces of the two objects rub against each other under pressure to form a fusion between molecular layers.

The arc welding refers to that electric arc is used as a heat source, and electric energy is converted into thermal energy and mechanical energy required for welding according to the physical phenomenon of air discharge, so as to achieve the purpose of connecting metals. The main methods include shielded metal arc welding, submerged arc welding, gas shielded welding, etc.

The laser welding is an efficient and precise welding method in which a high-energy density laser beam is used as a heat source.

The electron beam welding refers to that accelerated and focused electron beams are used to bombard a welding surface placed in vacuum or non-vacuum to melt welded workpieces so as to implement welding.

The pressure diffusion welding is a method in which a pressure is applied to welded workpieces to cause a certain plastic deformation of joint surfaces in close contact so as to implement welding.

The magnetic induction welding refers to that two welded workpieces collide instantaneously at a high speed under the action of a strong pulsed magnetic field, and under the action of high pressure waves on surface layers of materials, atoms of the two materials meet within an interatomic distance, so as to form stable metallurgical bonding on an interface. It is a type of solid-state cold welding in which conductive metals with similar or dissimilar properties may be welded together.

In the screwing, a wire and a connecting portion 13 have thread structures respectively, and can be screwed together or connected together using separate stud and nut. The screwing has the advantage of detachability, allows for repeated assembly and disassembly, and is applicable to scenes requiring frequent disassembly.

The crimping is a production process in which a crimping machine is used to stamp a wire and a connecting portion 13 as a whole. The crimping has the advantage of mass production. With interlocking terminals and an automatic crimping machine, products with stable quality can be quickly manufactured in large quantities.

The clamping refers to that a wire is in clamped connection with a connecting portion 13 by using a clamp or another component. The clamping has the advantage that the connection can be implemented by virtue of a tool without complex equipment, and is applicable to maintenance and other scenes.

The splicing refers to that corresponding grooves and protrusions are disposed on a wire and a connecting portion 13 respectively, and the wire and the connecting portion are assembled by mutually mortising or splicing the grooves and the protrusions, so as to be connected together. The splicing has the advantages of stable connection and detachability.

A threaded hole 14 is formed in the heat dissipation portion 12, the connecting portion 13 is in a cylindrical structure, the connecting portion 13 is externally provided with an external thread, and the connecting portion 13 is in threaded connection with the heat dissipation portion 12.

Further, the number of connecting portions 13 and the number of threaded holes 14 may be both plural, and a plurality of wires in the charging gun cable are connected to the connecting portions 13 in a one-to-one correspondence manner.

A main body of the connecting portion 13 is made of copper, and a surface thereof is plated with silver. It may also be made of a material with excellent electrical conductivity and thermal conductivity, such as aluminum containing graphene. For example, copper has good electrical conductivity and thermal conductivity, and is inexpensive; and silver, gold or other composite metals with good electrical conductivity has better electrical conductivity and thermal conductivity, but is expensive, however, if it used as a plating layer, it is possible to reduce costs on the basis of ensuring electrical conductivity and thermal conductivity. The connection with the cable may be crimping or connection such as resistance welding, laser welding, or vibration friction welding. A main structure of the connecting portion 13 has an inclination angle of 0.5° to be better matched with the heat dissipation portion.

A main body of the heat dissipation portion 12 is made of copper, and a surface thereof is plated with silver. It may also be made of a material with excellent electrical conductivity and thermal conductivity, such as aluminum containing graphene. For example, copper has good electrical conductivity and thermal conductivity, and is inexpensive; and silver, gold or other composite metals with good electrical conductivity has better electrical conductivity and thermal conductivity, but is expensive, however, if it used as a plating layer, it is possible to reduce costs on the basis of ensuring electrical conductivity and thermal conductivity. The surface area is as large as possible to achieve the purpose of effective heat dissipation, and heat dissipation ribs may also be provided on the surface to enlarge the area of the heat dissipation surface.

A main body of the terminal body 11 is made of copper, and a surface thereof is plated with silver. It may also be made of a material with excellent electrical conductivity, such as aluminum containing graphene. For example, copper has good electrical conductivity and thermal conductivity, and is inexpensive; and silver, gold or other composite metals with good electrical conductivity has better electrical conductivity and thermal conductivity, but is expensive, however, if it used as a plating layer, it is possible to reduce costs on the basis of ensuring electrical conductivity and thermal conductivity.

In addition, the charging gun having a cooling structure further includes a signal ground terminal 4, where a contour of the signal ground terminal 4 is cylindrical, and the signal ground terminal 4 is connected to the cable by means of crimping (which may also be resistance welding, laser welding, or vibration friction welding). A main body of the signal ground terminal 4 is made of copper, and a surface thereof is plated with silver. It may also be made of a material with excellent electrical conductivity, such as aluminum containing graphene. The main function of the signal ground terminal 4 is to transmit an electrical signal and lead static electricity into the ground in a timely manner to prevent electric shock.

In this embodiment, a cooling rate of the cooling structure 3 is greater than or equal to 0.5°C/min.

In order to verify the influence of the cooling rate of the cooling structure 3 on the temperature rise of the charging terminal 1, ten charging terminals 1 with the same sectional area, the same material and the same length are selected by the inventor and applied with the same current, cooling structures 3 with different cooling rates are used to cool the charging terminals 1, and temperature rises of the charging terminals 1 are read and recorded in Table 3.

The test method is to, in a closed environment, apply the same current to the charging terminals 1 having cooling structures 3 with different cooling rates, record temperatures before power on and stable temperatures after power on, and take absolute values of differences between the temperatures. In this embodiment, the temperature rise of less than 50 K is a qualified value.

**Table 3: Influence of cooling structures 3 with different cooling rates on temperature rises of charging terminals 1**

| Cooling rate (°C/min) of cooling structure | | | | | | | | | | | | |
|---|---|---|---|---|---|---|---|---|---|---|---|---|
| 0.01 | 0.03 | 0.05 | 0.1 | 0.3 | 0.5 | 1 | 2 | 3 | 4 | 5 | 6 | 7 |

| Temperature rise (K) of charging terminal | | | | | | | | | | | | |
|---|---|---|---|---|---|---|---|---|---|---|---|---|
| 63.8 | 58.5 | 55.6 | 52.7 | 50.2 | 48.5 | 41.4 | 37.1 | 33.2 | 30.9 | 27.5 | 26.8 | 26.5 |

It can be seen from the above Table 3 that when the cooling rate of the cooling structure 3 is less than 0.5°C/min, the temperature rise of the charging terminal 1 is unqualified, and the higher the cooling rate of the cooling structure 3 is, the lower the temperature rise of the charging terminal 1 is. Therefore, the cooling rate of the cooling structure 3 is set by the inventor to greater than or equal to 0.5°C/min.

In this embodiment, the charging gun having a cooling structure further includes a temperature sensor and a control board, where the temperature sensor is electrically connected to the control board through a data line. The temperature sensor and the control board may be disposed on the charging gun body 2, and the temperature sensor is in contact connection with the heat dissipation portion 12. With the temperature sensor, a worker can control a temperature inside the cooling structure at any time, and if the temperature is abnormal, it can be dealt with in time to avoid danger.

In this embodiment, the temperature sensor may be integrally formed with the heat dissipation portion 12. The control board is a circuit board, and a control logic circuit is disposed in the circuit board. The temperature sensor is a negative temperature coefficient (NTC) sensor or a positive temperature coefficient (PTC) sensor.

The advantages of using the two types of temperature sensors are that gaps that cannot be measured by other thermometers can be measured; they are convenient to use and the resistance may be arbitrarily selected within a range of 0.1 kΩ to100 kS2; and they are easily processed to be in complex shapes, may be produced in large quantities, have good stability and strong overload capacity, and are applicable to products requiring small size and stable performance such as adapters.

In some embodiments, a liquid leakage sensor is disposed on a surface of the cooling structure 3. Once the liquid leaks from the cooling structure 3, the liquid leakage sensor will detect it and transmit liquid leakage information by a data line, and the worker may deal with the case immediately. The specific liquid leakage sensor may be a water leakage sensing rope.

In some embodiments, a liquid leakage sensor is disposed inside the cooling structure 3. When the cooling structure 3 has the cooling jacket 34, the liquid leakage sensor is disposed in the cooling jacket 34. The liquid leakage sensor may determine whether the cooling structure 3 or the cooling jacket 34 leaks by monitoring the pressure intensity, pressure, flow rate or flow velocity in the cooling structure 3 or in the cooling jacket 34. When an abnormality occurs, the worker can know the abnormality through the liquid leakage sensor and deal with it in time.

Processing and forming of the charging gun havign a cooling structure will be described below.

The charging gun body 2 and the cooling structure 3 are processed and formed by means of an injection molding process, the dimensional requirements of the charging gun body 2 and the cooling structure 3 are met by controlling the equipment accuracy and a mold error, and the injection molding process is controlled by a mold locking force, an injection position, the measuring accuracy, an injection speed, an injection pressure, a mold temperature and the like, so as to meet the dimensional accuracy requirements of pre-assembly and rotation as well as the operational requirements of a rotational force.

Specific parameters are as follows:
less than 0.03 mm when the mold locking force is zero; less than 0.005 mm when the mold locking force is maximal;
the injection position accuracy (a pressure maintaining termination point) is less than 0.03 mm;
the injection speed is greater than or equal to 300 mm/s;
the injection pressure should be greater than 25 MPa; and
the temperature change of a mold should be controlled within ±1°C.

An automated assembly process is used for the heat dissipation portion 12, and the assembly process is controlled by an automated assembly fixture, so as to meet the requirements of a pre-assembly force, smooth coordination of motion of an L-shaped trajectory, a rotational force, a locking force, no wrong mounting, no missing mounting, no reverse mounting, etc.

The comparison between the technical effects of the charging gun having a cooling structure according to the present disclosure and the technical effects of an existing charging gun will be described below, as shown in Table 4.

**Table 4**

| | The prior art | The present disclosure |
|---|---|---|
| Charging time | 80% charge in 6-8 h | 80% charge in 8 min |
| Charging temperature | Controlled temperature rise of about 20°C | Controlled temperature rise of within 15°C |
| Charging power | 60KW | Maximally 550 KW |
| Cooling medium | No | Water + ethanediol |

### Embodiment 3

This embodiment is a variation of Embodiment 1. The main difference between this embodiment and Embodiment 1 is that the charging terminal 1 is of an integrated structure, the charging terminal 1 includes a terminal body 11, a heat dissipation portion 12, and a connecting portion 13 which are connected in sequence, the terminal body 11 is located in the charging gun body 2, and the heat dissipation portion 12 is located in the cooling structure 3.

Annular heat dissipation protrusions 121 are disposed on an outer peripheral surface of the heat dissipation portion 12, inner ring grooves are formed on an inner peripheral surface of the cooling structure 3, and the heat dissipation protrusions 121 are matched with and connected to the inner ring grooves, as shown in FIG. 7.

This embodiment has the advantage that the manufacturing and mounting efficiency of the charging terminal 1 may be improved. Other technical features in this embodiment may all be the same as those in Embodiment 1, and will not be described in detail in this embodiment for saving space.

### Embodiment 4

This embodiment is a variation of Embodiment 1. The main difference between this embodiment and Embodiment 1 is that the cooling-medium accommodating cavity 31 is wholly located in the cooling structure 3, and the cooling-medium accommodating cavities 31 do not need to be implemented with the sealed connection between the charging gun body 2 and the cooling structure 3. The cooling structure 3 includes an upper half cooling structure body 36 and a lower half cooling structure body 37 disposed in an up-and-down symmetrical way, and the upper half cooling structure body 36 and the lower half cooling structure body 37 are hermetically connected in a snap-fit manner, as shown in FIG. 8.

In this embodiment, there are one cooling medium inlet 32 and one cooling medium outlet 33, and the cooling structure 3 includes two cooling jackets 34, where the two cooling jackets 34 are a first cooling jacket and a second cooling jacket respectively, the cooling medium inlet 32 is located on the first cooling jacket, and the cooling medium outlet 33 is also located on the first cooling jacket, as shown in to FIG. 7. Alternatively, the cooling medium inlet 32 is located on the first cooling jacket, and the cooling medium outlet 33 is located on the second cooling jacket.

Other technical features in this embodiment may all be the same as those in Embodiment 1, and will not be described in detail in this embodiment for saving space.

### Embodiment 5

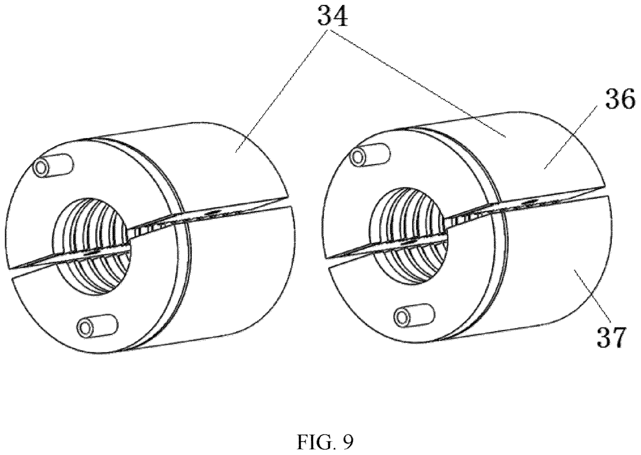

This embodiment is a variation of Embodiment 3. The main difference between this embodiment and Embodiment 3 is that a connecting plate 35 is disposed between two cooling jackets 34, there is no connecting channel in the connecting plate 35, the cooling medium accommodating cavities 31 in the two cooling jackets 34 do not communicate with each other, a cooling medium inlet 32 and a cooling medium outlet 33 are formed on each cooling jacket 34, and the cooling-medium accommodating cavity 31 does not need to be implemented with the sealed connection between the charging gun body 2 and the cooling structure 3, as shown in FIG. 9.

In this embodiment, there are two cooling medium inlets 32 and two cooling medium outlets 33, each of the two cooling jackets 34 of the cooling structure 3 includes an upper half cooling structure body 36 and a lower half cooling structure body 37 disposed in an up-and-down symmetrical way, and the upper half cooling structure body 36 and the lower half cooling structure body 37 are hermetically connected in a snap-fit manner. Alternatively, each of the two cooling jackets 34 of the cooling structure 3 includes a left half cooling structure body and a right half cooling structure body disposed in an left-and-right symmetrical way, and the left half cooling structure body and the right half cooling structure body are hermetically connected in a snap-fit manner.

In some embodiments, the cooling medium is cooling gas, cooling liquid, or cooling solid. The cooling gas may be obtained in a manner that refrigerated air is blown into the cooling structure 3 or the cooling jacket 34 to be cooled. The cooling liquid may include one or more selected from insulating water, ethylene glycol, castor oil, coconut oil, corn oil, cottonseed oil, linseed oil, olive oil, palm oil, peanut oil, grapeseed oil, rapeseed oil, safflower oil, sunflower oil, soybean oil, high oleic acid variants of various vegetable oils, 4-decenoic acid, decenoic acid, lauroleic acid, linderic acid, tetradecenoic acid, physeteric acid, tsuzuic acid, palmitoleic acid, petroselic acid, oleic acid, octadecenoic acid, gadoleic acid, gondoic acid, cetoleic acid, erucic acid, nervonic acid, glycerin, transformer oil, axle oil, internal combustion engine oil, and compressor oil. An additive may also be added into the cooling liquid, where the additive is selected from one or more selected from an antioxidant, a pour point depressant, a corrosion inhibitor, an antibacterial agent, and a viscosity modifier. Cooling oil has the advantages of sensitive thermal balance, super good thermal conductivity, ultra wide operating temperature range, no boiling, micro pressure of the cooling system, no need to add an antifreeze in a low temperature environment, no corrosion damage such as gas etching, scale, and electrolysis, etc. The cooling solid may be dry ice or the like. The dry ice is used as an example. The dry ice is disposed in the cooling structure 3 or the cooling jacket 34, and refrigeration equipment is applied outside the cooling structure and provides a cold source to maintain a solid state of the dry ice, so as to cool the charging terminal 1.

The present disclosure further provides a charging pile, which includes the above charging gun having a cooling structure.

In order to facilitate understanding and description, an absolute positional relationship is used for expression in the present disclosure. Unless otherwise specified, the directional word "up" represents an upper side direction in FIG. 5, the directional word "down" represents a lower side direction in FIG. 5, the directional word "left" represents a left side direction in FIG. 5, the directional word "right" represents a right side direction in FIG. 5, the directional word "front" represents a direction perpendicular to the paper surface of FIG. 5 and pointing to the inner side of the paper surface of FIG. 5, and the directional word "back" represents a direction perpendicular to the paper surface of FIG. 5 and pointing to the outer side of the paper surface of FIG. 5. The present disclosure is described from the perspective of a reader or a user, but the above directional words are not to be construed or interpreted as limiting the scope of protection of the present disclosure.

The above are only specific embodiments of the present disclosure, and cannot be used to limit the scope of implementation of the disclosure. Therefore, the replacement of equivalent components, or equivalent changes and modifications made in accordance with the scope of patent protection of the present disclosure shall still fall within the scope of the present patent. Additionally, in the present disclosure, the technical features may be freely combined with each other for use, the technical features may be freely combined with the technical solutions for use, and the technical solutions may be freely combined with each other for use.

## Claims

1. A charging gun having a cooling structure, comprising a charging terminal (1), a charging gun body (2), and a cooling structure (3), wherein the charging gun body (2) and the cooling structure (3) are disposed in sequence, the charging terminal (1) passes through the charging gun body (2) along a direction from the charging gun body (2) to the cooling structure (3), at least part of the charging terminal (1) is disposed in the cooling structure (3) in a matching manner, and the cooling structure (3) is capable of cooling the charging terminal (1) by a cooling medium in the cooling structure (3).

2. The charging gun having a cooling structure according to claim 1, wherein the charging terminal (1) comprises a heat dissipation portion (12) disposed in the cooling structure (3).

3. The charging gun having a cooling structure according to claim 1, wherein the cooling structure (3) is provided with a cooling-medium accommodating cavity (31) that allows the cooling medium to flow therein, and the cooling structure (3) is provided with a cooling medium inlet (32) and a cooling medium outlet (33).

4. The charging gun having a cooling structure according to claim 1, wherein an accommodating cavity (23) is formed in a front end of the charging gun body (2), a detachable structure is disposed in the accommodating cavity, and the charging terminal (1) is inserted into the accommodating cavity (23) through an opening of the accommodating cavity (23) and is detachably connected to the charging gun body (2) by the detachable structure.

5. The charging gun having a cooling structure according to claim 1, wherein the charging gun body (2) and the cooling structure (3) are integrally formed.

6. The charging gun having a cooling structure according to claim 2, wherein the charging terminal (1) further comprises a terminal body (11), the terminal body (11) is connected to the heat dissipation portion (12) by a thread structure, a bolt or an internal thread is disposed on the terminal body (11), a corresponding internal thread or bolt is disposed on the heat dissipation portion (12), and a torque of the thread structure for screw connection is 0.1 N·m to 30 N·m.

7. The charging gun having a cooling structure according to claim 6, wherein
when the bolt is disposed on the terminal body (11), a through hole is formed on the heat dissipation portion (12), and the bolt on the terminal body (11) passes through the through hole on the heat dissipation portion (12) and is connected to a nut;
when the internal thread is disposed on the terminal body (11), a through hole is formed on the heat dissipation portion (12), and a screw (17) passes through the through hole on the heat dissipation portion (12) and is connected to the internal thread on the terminal body (11);
when the internal thread is disposed on the heat dissipation portion (12), a through hole is formed on the terminal body (11), and a screw (17) passes through the through hole on the terminal body (11) and is connected to the internal thread on the heat dissipation portion (12);
when the bolt is disposed on the heat dissipation portion (12), a through hole is formed on the terminal body (11), and the bolt on the heat dissipation portion (12) passes through the through hole on the terminal body (11) is connected to a nut.

8. The charging gun having a cooling structure according to claim 2, wherein the charging terminal (1) further comprises a terminal body (11), a clamping jaw or a clamping groove is disposed on the terminal body (11), a corresponding clamping groove or clamping jaw is disposed on the heat dissipation portion (12), and a connecting force between the clamping jaw and the clamping groove is 5 N to 500 N.

9. The charging gun having a cooling structure according to claim 2, wherein a disassembly portion (15) is disposed at a rear end of the heat dissipation portion (12), and a section of the disassembly portion (15) is oblate or polygonal.

10. The charging gun having a cooling structure according to claim 2, wherein a plurality of charging terminals (1) are provided, the cooling structure (3) comprises a plurality of cooling jackets (34), the cooling jackets (34) are sleeved on peripheries of the heat dissipation portions (12) in a one-to-one correspondence manner, and a cooling medium inlet (32) and a cooling medium outlet (33) are formed on each of the cooling jackets (34).

11. The charging gun having a cooling structure according to claim 10, wherein a connecting channel is disposed between the cooling jackets (34), and cooling-medium accommodating cavities (31) of the cooling jackets (34) communicate with each other through the connecting channel.

12. The charging gun having a cooling structure according to claim 10, wherein the cooling structure (3) comprises two cooling jackets (34) which are a first cooling jacket and a second cooling jacket respectively; the cooling medium inlet (32) is located on the first cooling jacket and/or the second cooling jacket; and the cooling medium outlet (33) is located on the first cooling jacket and/or the second cooling jacket.

13. The charging gun having a cooling structure according to claim 10, wherein a heat dissipation protrusion (121) is disposed on an outer peripheral surface of the heat dissipation portion (12), an inner ring groove is formed on an inner peripheral surface of the cooling jacket (34), and the heat dissipation protrusion (121) is matched with and connected to the inner ring groove.

14. The charging gun having a cooling structure according to claim 1, wherein a mounting groove (21) is formed on a mounting surface of the charging gun body (2) facing the cooling structure (3), an opening is formed at a front end of the cooling structure (3), the front end of the cooling structure (3) is matched with and inserted into the mounting groove (21), the cooling structure (3) is connected to the charging gun body (2) to form a cooling-medium accommodating cavity (31), and a front end of the cooling-medium accommodating cavity (31) is closed by the charging gun body (2).

15. The charging gun having a cooling structure according to claim 2, wherein a connecting portion (13) is disposed in the heat dissipation portion (12), and the connecting portion (13) is connected to a charging gun cable by one or more selected from resistance welding, friction welding, ultrasonic welding, arc welding, laser welding, electron beam welding, pressure diffusion welding, magnetic induction welding, screwing, clamping, splicing, and crimping.

16. The charging gun having a cooling structure according to claim 15, wherein the heat dissipation portion (12) is internally provided with a threaded hole (14), the connecting portion (13) is externally provided with an external thread, and the connecting portion (13) is in threaded connection with the heat dissipation portion (12).

17. The charging gun having a cooling structure according to claim 16, wherein a plurality of connecting portions (13) and a plurality of threaded holes (14) are provided, and a plurality of wires in the charging gun cable are connected to the connecting portions (13) in a one-to-one correspondence manner.

18. The charging gun having a cooling structure according to claim 1, wherein a cooling rate of the cooling structure (3) is greater than or equal to 0.5°C/min.

19. The charging gun having a cooling structure according to claim 1, further comprising a temperature sensor and a control board, wherein the temperature sensor is electrically connected to the control board through a data line.

20. The charging gun having a cooling structure according to claim 19, wherein the temperature sensor is in contact connection with the charging terminal (1).

21. The charging gun having a cooling structure according to claim 19, wherein the temperature sensor is integrally formed with the charging terminal (1).

22. The charging gun having a cooling structure according to claim 19, wherein the control board is a circuit board, and a control logic circuit is disposed in the circuit board.

23. The charging gun having a cooling structure according to claim 19, wherein the temperature sensor is a negative temperature coefficient sensor or a positive temperature coefficient sensor.

24. The charging gun having a cooling structure according to claim 1, wherein a liquid leakage sensor is disposed on a surface of the cooling structure (3).

25. The charging gun having a cooling structure according to claim 1, wherein a liquid leakage sensor is disposed inside the cooling structure (3).

26. The charging gun having a cooling structure according to claim 1, wherein the cooling medium is cooling gas, cooling liquid, or cooling solid.

27. A charging pile, comprising the charging gun having a cooling structure according to any one of claims 1 to 26.
